(19) Europäisches Patentamt / European Patent Office / Office européen des brevets

(11) **EP 1 956 442 A1**

(12) **EUROPEAN PATENT APPLICATION**
published in accordance with Art. 158(3) EPC

(43) Date of publication:
**13.08.2008 Bulletin 2008/33**

(51) Int Cl.:
*G03G 15/16* (2006.01)  *C23C 16/30* (2006.01)

(21) Application number: **06823054.9**

(22) Date of filing: **07.11.2006**

(86) International application number:
**PCT/JP2006/322141**

(87) International publication number:
**WO 2007/063679 (07.06.2007 Gazette 2007/23)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.11.2005 JP 2005345429**

(71) Applicant: **KONICA MINOLTA BUSINESS TECHNOLOGIES, INC.**
**Tokyo 100-0005 (JP)**

(72) Inventor: **MAEHARA, Yuichiro**
**Hino-shi**
**Tokyo 191-8511 (JP)**

(74) Representative: **Gille Hrabal Struck Neidlein Prop Roos**
**Patentanwälte**
**Brucknerstrasse 20**
**40593 Düsseldorf (DE)**

(54) **INTERMEDIATE TRANSFER MEMBER, PROCESS FOR PRODUCING THE SAME AND IMAGE FORMING APPARATUS**

(57)  An objective is to provide an intermediate transfer member exhibiting higher transferability together with higher cleaning ability and durability, a manufacturing apparatus of an intermediate transfer member in which no large-scale equipment such as a vacuum evaporator or the like is managed to be installed, and an image forming apparatus fitted with the intermediate transfer member. Also disclosed is intermediate transfer member 170 possessing ceramic film 176 provided on substrate 175, wherein ceramic film 176 has a density of ρf, satisfying the following formula: $0.8 < \rho f/\rho b \leq 1$, provided that another ceramic film having the same composition ratio as that of ceramic film 176 has a density of ρb when the another ceramic film is formed via thermal oxidation or thermal nitridation of a base material.

FIG. 1

EP 1 956 442 A1

**Description**

**TECHNICAL FIELD**

The present invention relates to an intermediate transfer member, a method of manufacturing the intermediate transfer member and an image forming apparatus fitted with the intermediate transfer member to be transferred by synthesizing a toner image with respect to each of colors for a color image in electrophotographic apparatuses and electrostatic recording apparatuses such as an electronic copying machine, a laser beam printer, a facsimile machine and so forth.

**BACKGROUND**

In the past, as a method of transferring a toner image on an electrophotographic photoreceptor (hereinafter, also referred to simply as a photoreceptor) onto a recording material for a final image, there has been known a method of direct transfer of a toner image formed on an electrophotographic photoreceptor onto a recording material. On the other hand, there is known an image forming system, the system employing an intermediate transfer member, in which a transfer process of transferring a toner image from an electrophotographic photoreceptor to a recording material incorporates another transfer process, wherein the toner image is primarily transferred from the electrophotographic photoreceptor to the intermediate transfer member, then the primary transfer image in the intermediate transfer member is secondarily transferred to the recording member, thereby the image forming system obtaining a final image. An intermediate transfer system as described above is mostly employed as a superimposing transfer system that superimposes toner images of respective colors in a so-called full color image forming apparatus, wherein the superimposing transfer system reproduces an original image, the original image having been color-separated, with use of a subtractive mixture of toners of black, cyan, magenta, yellow, etc.

However, in the case of a superimposing transfer system fitted with this intermediate transfer member, image failure caused by transfer failure of a toner image tends to be generated since transferring twice such as the primary transfer and the secondary transfer is conducted, and four color toners are also superimposed on the intermediate transfer member.

It is commonly known that transfer efficiency can be improved by treating the toner surface with additives such as silica and the like against transfer failure of toner. However, there is a problem such that sufficient transfer efficiency can not be obtained since silica is removed from the toner surface, and embedded inside the toner because of stress influenced from a stirring member of toner in a developing device, stress influenced from a regulation blade to form a toner layer on a developing roller, stress influenced between a photoreceptor and a developing roller, and so forth.

In order to solve such the problem, it is disclosed that detachability of toner images is improved by coating silicon oxide, aluminum oxide or the like onto the intermediate transfer member surface, whereby transfer efficiency to a recording paper sheet or such is tried to be improved (refer to Patent Documents 1 and 2, for example).

Patent Document 1: Japanese Patent O.P.I. Publication No. 9-212004

Patent Document 2: Japanese Patent O.P.I. Publication No. 2001-347593

**DISCLOSURE OF THE INVENTION**

**PROBLEMS TO BE SOLVED BY THE INVENTION**

However, since in the case of an image forming apparatus fitted with an intermediate transfer member, it is nearly impossible at present to transfer 100% of toner images during secondary transfer, a cleaning device to scrape residual toner off the intermediate transfer member with a blade is desired to be arranged, for example.

There is a problem such that life of an intermediate transfer member is short, since durability of the intermediate transfer member described in Patent Documents 1 and 2 is insufficient. There is also a problem such that image defects tend to be generated because of scratched thin films caused by paper jam or the like, since thin films are easily scratched by disturbance because of insufficient film coating and film strength. Further, there was a problem concerning productivity such that large-scale equipment such as a vacuum evaporator or the like is demanded since silicon oxide, aluminum oxide and so forth are arranged to be deposited via vacuum evaporation or sputtering.

In consideration of the above-described problem, it is an object of the present invention to provide an intermediate transfer member exhibiting higher transferability together with higher cleaning ability and durability, a manufacturing apparatus of an intermediate transfer member in which no large-scale equipment such as a vacuum evaporator or the like is managed to be installed, and an image forming apparatus fitted with the intermediate transfer member.

## MEANS TO SOLVE THE PROBLEMS

The foregoing problems were solved by utilizing any one of the following structures via considerable effort during intensive studies done by the inventor.

(Structure 1) An intermediate transfer member comprising a ceramic film provided on a substrate, wherein the ceramic film has a density of pf, satisfying the following formula:

$$0.8 < \rho f / \rho b \leq 1$$

provided that another ceramic film having the same composition ratio as that of the ceramic film has a density of pb, when the another ceramic film is formed via thermal oxidation or thermal nitridation of a base material.

(Structure 2) The intermediate transfer member of Structure 1, wherein the ceramic film having the density of pf has a residual stress as a compression stress of 0.01 - 100 MPa.

(Structure 3) The intermediate transfer member of Structure 1 or 2, wherein a material constituting the ceramic film having the density of pf is silicon oxide, silicon oxide-nitride, silicon nitride, titanium oxide, titanium oxide-nitride, titanium nitride, aluminum oxide, or a mixture thereof.

(Structure 4) The intermediate transfer member of any one of structures, 1 - 3, wherein the ceramic film having the density of pf is silicon oxide has a thickness of 200 - 1000 nm.

(Structure 5) A method of manufacturing the intermediate transfer member of any one of Structures 1 - 4, comprising the steps of supplying a gas comprising a thin film forming gas into a discharge space at atmospheric pressure or approximately atmospheric pressure; applying a high frequency electric field to the discharge space to excite the gas; and exposing a substrate to the excited gas to form the ceramic film on a surface of the substrate.

(Structure 6) An image forming apparatus comprising a device of developing a surface of an image carrier to form a toner image; a device of transferring the toner image into an intermediate transfer member; and a device of further transferring the toner image onto a transfer paper sheet, wherein the intermediate transfer member is the intermediate transfer member of any one of Structures 1 - 4.

## EFFECT OF THE INVENTION

The present invention can produce the following effects. That is, when a ceramic film is provided on a substrate of an intermediate transfer member, the ceramic film has a density pf, and also another ceramic film having the same composition ratio as that of the ceramic film, which is formed via thermal oxidation or thermal nitridation of a base material, has a density of pb, an intermediate transfer member possessing a dense ceramic film exhibiting excellent adhesion to the substrate with less cracks, which exhibits an excellent releasing property of toner together with high cleaning property and durability can be obtained by satisfying the following formula 0.8 <pf/pb ≤ 1, and a method of manufacturing the foregoing intermediate transfer member and an image forming apparatus fitted with the intermediate transfer member can be also obtained.

## BRIEF DESCRIPTION OF THE DRAWINGS

Fig. 1 is a cross-sectional schematic diagram showing an example of a color image forming apparatus.
Fig. 2 is a conceptual cross-sectional view showing a layer structure of the intermediate transfer member.
Fig. 3 shows the relationship between a vacuum degree and residual stress of a silicon oxide film formed by a vacuum evaporation method.
Fig. 4 is a schematic diagram of the first manufacturing apparatus to produce an intermediate transfer member.
Fig. 5 is a schematic diagram of the second manufacturing apparatus to produce an intermediate transfer member.
Fig. 6 is a schematic diagram of the first plasma film-forming apparatus to produce an intermediate transfer member employing plasma.

## EXPLANATION OF NUMERALS

1 Color image forming apparatus

2 Manufacturing apparatus of intermediate transfer member

3 Atmospheric pressure plasma CVD apparatus

4 Atmospheric pressure plasma apparatus

17 Intermediate transfer member unit

20 Roll electrode

21 Fixed electrode

23 Discharge space

24 Mixed gas supply device

25 First power supply

26 Second power supply

41 Thin film forming area

117 Secondary transfer roller

170 Intermediate transfer belt

175 Substrate

176 Ceramic film

201 Driven roller

## DESCRIPTION OF THE PREFERRED EMBODIMENTS

Embodiments of the present invention will be described below, but the following description limits neither technical scope nor definition of terms of the claims thereto.

An intermediate transfer member of the present invention is preferably used in an image forming apparatus such as an electrophotographic type copier, printer and facsimile. Any type of a transfer member is applicable as long as a toner image held on the surface of a photoreceptor is primarily transferred to the surface of the transfer member, the transfer member holds the transferred toner image, and the transfer member secondarily transfers the held toner image to the surface of an image forming material such as a recording sheet, onto which to transfer the image, wherein the intermediate transfer member may be in a belt form or in a drum shape.

First, an image forming apparatus fitted with an intermediate transfer member of the present invention will be described, taking a tandem type full-color copier as an example.

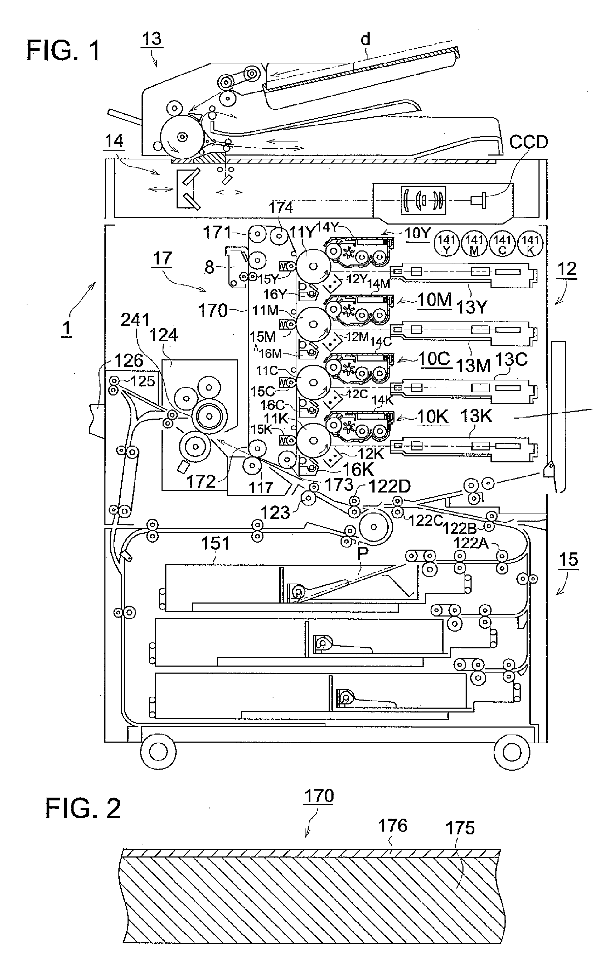

Fig. 1 is a cross-sectional schematic diagram showing an example of a color image forming apparatus.

Color image forming apparatus 1 is called a tandem type full-color copier, and is fitted with automatic document conveying device 13, original document reading device 14, plural exposure units 13Y, 13M, 13C and 13K, plural image forming sections 10Y, 10M, 10C and 10K, intermediate transfer member unit 17, sheet feeding unit 15 and fixing device 124.

Around the upper portion of main body 12 of the image forming apparatus, disposed are automatic document conveying device 13 and original document reading device 14. An image of original document d conveyed by automatic document conveying device 13 is reflected and caused to form an image by an optical system of image reading device 14, and the image is read by line image sensor CCD.

An analog signal produced by photoelectric conversion of an image of an original document read by the line image sensor CCD is subjected, in an image processing section (not shown), to analog processing, A/D conversion, shading calibration, image compression processing and the like, thereafter transmitted to exposure units 13Y, 13M, 13C and 13K as digital image data of the respective colors, and then latent images of the image data of the respective colors are formed by exposure units 13Y, 13M, 13C and 13K on photoreceptors 11Y, 11M, 11C and 11K in the form of drum (hereinafter, also referred to as photoreceptors) as corresponding first image carriers.

Image forming sections 10Y, 10M, 10C and 10K are disposed in tandem in the vertical direction, and an intermediate transfer member (hereinafter, referred to as an intermediate transfer belt) 170, in accordance with the present invention, which is a second image carrier being semiconductive and in an endless belt form is disposed on the left side, in the figure, of photoreceptors 11Y, 11M, 11C and 11K, wherein intermediate transfer belt 170 is wound around rollers 171, 172, 173 and 174 and thus rotatably tension-supported.

Intermediate transfer belt 170 of the present invention is driven along the arrow direction through roller 171 which is rotationally driven by an unshown drive unit.

Image forming section 10Y for forming yellow color images includes charging unit 12Y, exposure unit 13Y, development unit 14Y, primary transfer roller 15Y as a primary transfer device, and cleaning unit 16Y which are disposed around photoreceptor 11Y.

Image forming section 10M for forming magenta color images includes photoreceptor 11M, charging unit 12M, exposure unit 13M, development unit 14M, primary transfer roller 15M as a primary transfer device, and cleaning unit 16M.

Image forming section 10C for forming cyan color images includes photoreceptor 11C, charging unit 12C, exposure unit 13C, development unit 14C, primary transfer roller 15C as a primary transfer device, and cleaning unit 16C.

Image forming section 10K for forming black color images includes photoreceptor 11K, charging unit 12K, exposure unit 13K, development unit 14K, primary transfer roller 15K as a primary transfer device, and cleaning unit 16K.

Toner supply units 141Y, 141M, 141C and 141K supply new toner to respective development units 14Y, 14M, 14C and 14K.

Herein, primary transfer rollers 15Y, 15M, 15C and 15K are selectively operated by an unshown control unit corresponding to the image type, and press intermediate transfer belt 170 against respective photoreceptors 11Y, 11M, 11C and 11K to transfer images on the photoreceptors.

In such a manner, the images in the respective colors formed on photoreceptors 11Y, 11M, 11C and 11K by image forming sections 10Y, 10M, 10C and 10K are sequentially transferred to circulating intermediate transfer belt 170 by primary transfer rollers 15Y, 15M, 15C and 15K so that synthesized color images are formed.

That is, the toner images carried on the surfaces of the photoreceptors are primarily transferred to the surface of the intermediate transfer belt, and the intermediate transfer belt holds the transferred toner image.

Recording sheet P as a recording medium stored in sheet supply cassette 151 is fed by sheet feeding unit 151, then conveyed into secondary transfer roller 117 as a secondary transfer device through plural intermediate rollers 122A, 122B, 122C, 122D and registration roller 123, and then the synthesized toner images on the intermediate transfer member are transferred all together onto recording sheet P by secondary transfer roller 117.

That is, the toner image held on the intermediate transfer member is secondarily transferred onto the surface of the transferred material.

Herein, secondary transfer roller 6 presses recording medium P against intermediate transfer belt 170 only when recording medium P passes through here to perform secondary transferring.

Recording sheet P onto which the color image has been transferred is subjected to a fixing treatment by fixing device 124, and nipped by sheet-ejection rollers 125 to be loaded on sheet-ejection tray 126 equipped outside the apparatus.

On the other hand, after the color image is transferred to recording medium P by secondary transfer roller 117, residual toner on intermediate transfer belt 170 having curvature-separated recording sheet P is removed by cleaning unit 8.

Herein, the intermediate transfer member may be replaced by a rotatable intermediate transfer drum as described above.

Next, the structure of primary transfer rollers 15Y, 15M, 15C and 15K as first transfer units being in contact with intermediate transfer belt 170, and the structure of secondary transfer roller 117 will be described.

Primary transfer rollers 15Y, 15M, 15C and 15K are formed, for example, by coating the circumferential surface of a conductive core metal of stainless or the like with an outer diameter of 8 mm, with a semiconductive elastic rubber having a thickness of 5 mm and a rubber hardness in an approximate range of 20 - 70 degrees (Asker hardness C). Herein, the semiconductive elastic rubber is prepared by making a rubber material such as polyurethane, EPDM, silicon or the like into a solid state or foam sponge state with a volume resistance in an approximate range of $10^5 - 10^9$ $\Omega$-cm, dispersing conductive filler such as carbon, to the rubber material or having the rubber material contain an ionic conductive material.

Secondary transfer roller 117 is formed, for example, by coating a circumferential surface of a conductive core metal of stainless or the like with an outer diameter of 8 mm, with a semiconductive elastic rubber having a thickness of 5 mm and a rubber hardness in an approximate range from 20 to 70 degrees (Asker hardness C). Herein, the semiconductive elastic rubber is prepared by making a rubber material, such as polyurethane, EPDM, silicon or the like into a solid state or foam sponge state with a volume resistance in an approximate range of $10^5 - 10^9$ $\Omega$·cm, dispersing conductive filler such as carbon, to the rubber material or having the rubber material contain an ionic conductive material.

Herein, secondary transfer roller 117 is different from each of primary transfer rollers 15Y, 15M, 15C and 15K in that toner can contact secondary transfer roller 6 in a state where no recording sheet P is present. Accordingly, the surface of secondary transfer roller 117 is preferably coated with a material exhibiting a sufficient releasing property, such as a semiconductive fluorine resin, urethane resin or the like. Secondary transfer roller 117 is formed by coating a circumferential surface of a conductive core metal of stainless or the like, with a semiconductive material having a thickness in an approximate range from 0.05 to 0.5 mm. Herein, the semiconductive material is prepared by dispersing conductive filler such as carbon, to a rubber or resin material such as polyurethane, EPDM, silicon or the like, or having the rubber or resin material contain an ionic conductive material.

An intermediate transfer member of the present invention will be described below, taking intermediate transfer belt 170 as an example.

Fig. 2 is a conceptual cross-sectional view showing a layer structure of the intermediate transfer member.

Intermediate transfer belt 170 comprises substrate 175 and ceramic film 176 provided on the surface of substrate 175. Ceramic film 176 is composed of one ceramic film or more. When the ceramic film has a density pf, and another ceramic film having the same composition ratio as that of the ceramic film, that is formed via thermal oxidation or thermal nitridation of a base material, has a density of pb, the resin film comprises a ceramic film formed so as to satisfy that density Y (= pf/pb) is 1 ≥ Y > 0.8.

This ceramic film preferably has a residual stress as a compression stress of 0.01 - 100 MPa. In this way, an intermediate transfer member exhibiting high transfer efficiency of toner together with high cleaning ability and durability is obtained.

Next, structural factors of intermediate transfer belt 170 of the present invention will be described.

(Substrate)

A belt formed by dispersing a conductive agent in a resin material is usable as substrate 175 for intermediate transfer belt 170 of the present invention. Examples of the resin usable for the belt include so-called engineering plastic materials such as polycarbonate, polyimide, polyetherether ketone, polyvinylidene fluoride, an ethylenetetrafluoroethylene copolymer, polyamide, polyphenylene sulfide and so forth- Carbon black can also be used as the conductive agent, and neutral or acidic carbon black can be used as the carbon black. The conductive filler may be added in such a way that volume resistance and surface resistance of intermediate transfer belt 170 are in the predetermined range, depending on kinds of the employed conductive filler. The consumption amount of the conductive filler is commonly 10 - 20 parts by weight, and preferably 10 - 16 parts by weight with respect to 100 parts by weight of resin material. Substrate 175 employed for the present invention is possible to be manufactured by a commonly known conventional method. For example, a resin as a material is dissolved in an extruder, and rapidly cooled via extrusion with a ring die or a T-die to prepare it.

Substrate 175 has a thickness of 50 - 200 μm in the case of a resin material, and a thickness of 300 - 700 μm in the case of a rubber material.

(Ceramic film)

Next, ceramic film 176 of the present invention is formed on substrate 175.

In the present invention, ceramic film 175 formed on substrate 175 should be formed in such a way that density Y (= pf/pb) is 1 ≥ Y > 0.8, when the ceramic film formed via thermal oxidation or thermal nitridation of a base material has a density of ρb, so as to obtain the same composition ratio as that of the ceramic film having a density of pf. In the present invention, the density of ceramic film 176 formed on substrate 175 can be obtained by a commonly known technique of analysis, but in the present invention, the value obtained via an X-ray reflectivity method is employed.

This is a measuring method by which an X-ray enters a material having the flat surface at a very shallow angle, and the X-ray reflectometry measurement can be made referring to page 151 of "Hand Book of X Ray Diffraction" edited by Rigaku Denki Co., Ltd. (published by Kokusai Bunken Insatsu Corp., 2000) and No. 22 of "Kagaku Kougyo"(January 1999).

A specific example of the measuring method usable in the present invention will be described below.

The measurement is conducted employing a measuring apparatus MAC Science MXP21. Cu is used as a target of an X-ray source to operate at 42 kV and 500 mA. A multilayer parabolic mirror is employed for an incident monochromator-An entrance slit of 0.05 mm x 5 mm and an acceptance of 0.03 mm x 20 mm are used. Measurement from 0° to 5° by a step width of 0.005° is carried out with 10 seconds for one step employing a FT method. Curve fitting is conducted for the resulting reflectivity curve employing MAC Science Reflectivity analysis Program Ver.1 to determine each of parameters so as to minimize the residual sum of squares between the actual measurement value and the fitting curve. Thickness and density of a multilayer film can be determined from each of the resulting parameters. Each layer thickness of the multilayer film in the present invention can also be evaluated via the above-described reflectivity measurement.

This method can be used, for example, to measure the density (pf) of the ceramic film made of silicon oxide, silicon nitride or silicon oxynitride formed via the after-mentioned atmospheric pressure plasma method or evaporation method.

The ceramic film is desired to be dense and density ratio Y (= pf/pb), which is a ratio with respect to density (pb) of a bulk ceramic (bulk silicon oxide in cases where the formed ceramic film is a silicon oxide film) of which the identical composition is to be made, is preferably within the foregoing range. It is preferable that the closer to the bulk composition, the more dense the film is. A method by which such the film is stably prepared is preferable.

A base material of ceramic film 176, formed so as to obtain the same composition as that of ceramic film 176 formed on substrate 175 via evaporation or plasma CVD, for example, is subjected to thermal oxidation or thermal nitridation to form a ceramic film as a film of the above-described bulk, and the density of the ceramic film is employed. In the case of silicon oxide as a base material, a base metal, that is, a silicon substrate corresponding to this is utilized.

A silicon oxide film formed via thermal oxidation of a silicon substrate is commonly known, and a thermally oxidized film is formed on the surface of the silicon substrate employing the silicon substrate. Properties of the silicon oxide film are well known through intensive studies in the field of semiconductors. It is known that the silicon oxide film has an approximately 1 nm thick transition layer having a different structure from that of bulk silicon oxide in the area close to the boundary with silicon substrate, but the bulk silicon oxide film having a sufficient thickness of 10 - 300 nm, for example is desired to be formed so as not to have an influence of this area. Further, in the case of the silicon oxide layer, for example, since an oxide film comprising a thin transition layer is formed at low temperature employing ozone or the like, this method may be allowed to be used.

The foregoing statement also applies to an oxynitrided film, nitrided film and so forth. The ceramic film is formed from the base material, for example, a metal substrate to form a ceramic film having the identical composition via thermal oxynitridation or nitridation by adjusting such conditions as the type and flow rate of gas, temperature and time and so forth. Density (pb) of the bulk is measured by the foregoing X-ray reflectivity method.

Further, ceramic film 176 formed on substrate 175 is preferably has a residual stress as a compression stress of 0.01 - 100 MPa.

For example, when a substrate film having a ceramic film formed via an evaporation method, a CVD method, a sol-gel method or such is left standing under the predetermined condition, the positive curl and negative curl are generated in the relationship of film quality between the substrate film and the ceramic film. This curl is produced by stress generated in the foregoing ceramic film. The larger the amount of curl (positive), the larger the compression stress is.

The following method is utilized to measure internal stress of the ceramic film. A ceramic film having the same composition and thickness as those of the film to be measured is formed on a quartz substrate having a width of 10 mm, a length of 50 mm and a thickness of 0.1 mm in accordance with the same procedure so as to give a film thickness of 1 $\mu$m. The curl generated in the prepared sample is measured by turning the concave portion of the sample up, employing a thin film property evaluation device MH4000, manufactured by NEC Sanei Co., Ltd. Generally, positive curl in which the film side is contracted against the substrate by compression stress is expressed by positive stress. In contrast, when negative curl generated by tensile stress is expressed by negative stress.

In the present invention, the stress value is preferably 200 MPa or less in the positive range, and more preferably 0.01 - 100 MPa.

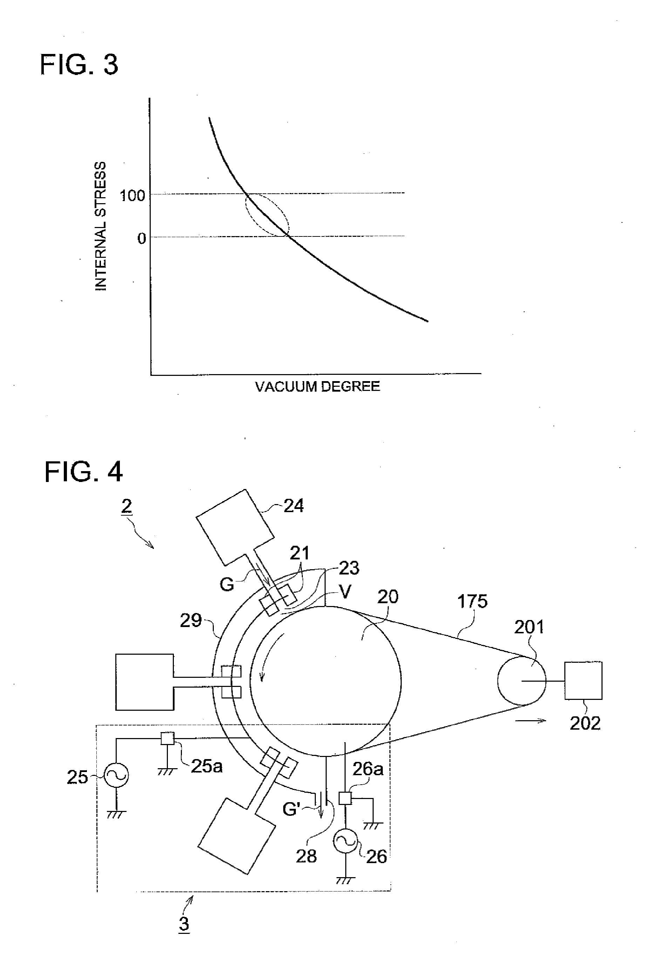

The residual stress of an intermediate member in which a silicon oxide film is formed can be cntrolled by adjusting a vacuum degree when the silicon oxide film is formed by a vacuum evaporation method, for example. Fig. 3 shows the relationship between the vacuum degree within a chamber when a 1 $\mu$m-thick silicon oxide film is formed on a quartz substrate having a width of 10 mm, a length of 50 mm and a thickness of 0.1 mm in accordance with the identical procedure by the vacuum evaporation, and the residual (internal) stress of the formed silicon oxide film measured by the foregoing method. In the figure, a ceramic film having a residual stress of 0 - approximately 100 MPa is preferable, but fine adjustment is difficult and fine control is specifically difficult, whereby it cannot reach this range frequently in many cases. In the case of very small stress, partial tensile stress is sometimes generated, and the film exhibits less durability since cracks and fracture are easy to be generated. In the case of very large stress, the film is easy to be cracked, and tends to be easily peeled off.

Ceramic film 176 of the present invention has a thickness of 200 - 1000 nm, preferably has a thickness of 200 - 600 nm, and more preferably a thickness of 220 - 500 nm.

In the case of ceramic film 176 having a thickness of less than 200 nm, rubbing scratches are generated via transfer into a heavy paper sheet, and end up with uneven wear of a thin film because of insufficient durability and surface strength, whereby the toner transfer ratio is lowered, and transfer unevenness is generated. In the case of ceramic film 176 having a thickness exceeding 1000 nm, it is not preferable in view of productivity that not only cracking and peeling tend to be generated via repetitive use, but also a duration to form a film is increased because of insufficient adhesion and flexing resistance.

Ceramic film 176 of the present invention is preferably made of silicon oxide, silicon oxide-nitride, silicon nitride, titanium oxide, titanium oxide-nitride, titanium nitride or aluminum oxide, and is also preferably made of a mixture thereof.

Ceramic film 176 of the present invention may be composed of at least one layer.

Before forming ceramic film 176 on substrate 175 in the present invention, the substrate may be subjected to a surface treatment such as a corona treatment, a flame treatment, a plasma treatment, a glow discharge treatment, a roughened surface treatment or a chemical treatment.

In order to improve adhesion, an anchor coating agent layer may be formed between ceramic film 176 and substrate 175 in the present invention. Examples of the anchor coating agent used for this anchor coating agent layer include a polyester resin, an isocyanate resin, a urethane resin, an acryl resin, an ethylene vinyl alcohol resin, a vinyl modified resin, an epoxy resin, a modified styrene resin, a modified silicon resin, an alkyl titanate and so forth, and these may be used singly or in combination with at least two kinds. Conventionally known additives can also be added into these anchor coating agents. The above-described anchor coating agent can be coated on a substrate by a commonly known method such as a roll coating method, a gravure coating method, a knife coating method, a dip coating method, a spray coating method or the like to conduct anchor coating via drying and removing of a solvent, a dilutant and so forth, and via UV curing. It is preferable that a coating amount of the above-described anchor coating agent is roughly 0.1 - 5 g/m$^2$. (when dried).

Next, an apparatus, method and using gas in the case of forming a ceramic film of an intermediate transfer member of the present invention via atmospheric pressure plasma CVD will be described.

Fig. 4 is a schematic diagram of the first manufacturing, apparatus to produce an intermediate transfer member.

Manufacturing apparatus 2 of an intermediate transfer member (a direct type in which the electric discharge space and the thin film depositing area are substantially identical) which forms ceramic film 176 on substrate 175, includes: roll electrode 20 that rotatably supports substrate 175 of endless belt-shaped intermediate transfer member 170 and rotates in the arrow direction; driven roller 201; and atmospheric pressure plasma CVD device 3 which is a film-forming device to form ceramic film 176 on the surface of substrate 175.

Atmospheric pressure plasma CVD device 3 includes: at least one set of fixed electrode 21 disposed along the outer circumference of roll electrode 20; electric discharge space 23 which is a facing region between fixed electrode 21 and roll electrode 20 where electric discharge is performed; mixed gas supply device 24 which produces mixed gas G of at least a raw material gas and a discharge gas to supply mixed gas G to discharge space 23; electric discharge container 29 which reduces air flow into, for example, discharge space 23; first power supply 25 connected to roll electrode 20; second power supply 26 connected to fixed electrode 21; and gas exhaustion section 28 for used exhausting gas G' .

Mixed gas supply device 24 supplies a mixed gas of a raw material gas and nitrogen gas or a rare gas such as argon gas, into discharge space 23, in order to form a film possessing at least one layer selected from an inorganic oxide layer, an inorganic nitride layer and an inorganic carbide layer. In addition, oxygen gas or hydrogen gas is more preferably mixed in order to accelerate reaction via oxidation-reduction reaction.

Driven roller 201 is pulled in the arrow direction by tension-providing unit 202 and applies a predetermined tension to substrate 175. Tension-providing unit 202 releases providing of tension, for example, during replacement of substrate 175, allowing easy replacement of substrate 175.

First power supply 25 provides a voltage of frequency ω1, second power supply 26 provides a voltage of frequency of ω2, and these voltages generate electric field V where frequencies ω1 and ω2 are superposed in discharge space 23. Electric field V plasmatizes mixed gas G to deposit a film (ceramic film 176) on the surface of substrate 175, corresponding to the raw material gas contained in mixed gas G.

Herein, ceramic film 176 may be deposited in lamination employing the mixed gas supply devices and the plural fixed electrodes disposed on the downstream side with respect to the rotation direction of the roll electrode, among the plural fixed electrodes, so as to adjust the thickness of ceramic film 176.

Further, ceramic film 176 may be deposited employing the mixed gas supply devices and the fixed electrodes disposed on the downstream side with respect to the rotation direction of the roll electrode, among the plural fixed electrodes, while another layer, for example, a adhesive layer to improve adhesion between ceramic film 176 and substrate 175, may be formed by the other mixed gas supply devices and fixed electrodes disposed on the upperstream side.

Further, in order to improve adhesion between ceramic film 176 and substrate 175, gas supply devices to supply gas, such as argon gas or oxygen gas, and fixed electrodes may be arranged on the upstream side of the fixed electrodes and the mixed gas supply devices that form ceramic film 176, so as to conduct a plasma treatment and thereby activating the surface of substrate 175.

As described above, an intermediate transfer belt being an endless belt is tension-supported by a pair of rollers; one of the pair of rollers is used for one of a pair of electrodes; at least one fixed electrode as the other electrode is provided along the outer circumferential surface of the roller which works as the one electrode; an electric filed is generated between the pair of electrodes at an atmospheric pressure or an approximately atmospheric pressure to perform plasma discharge, so that a thin film is deposited and formed on the surface of the intermediate transfer member. Thus, it is possible to provide an intermediate transfer member exhibiting high transferability, high cleaning performance and high durability.

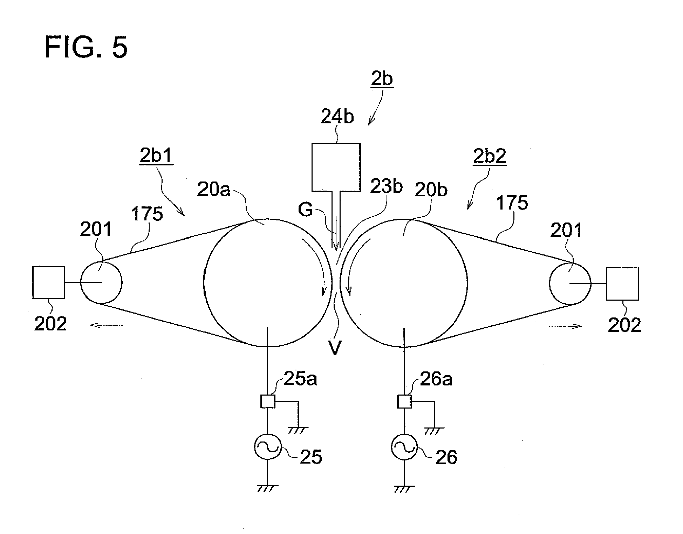

Fig. 5 is a schematic diagram of the second manufacturing apparatus to produce an intermediate transfer member.

Second manufacturing apparatus 2b for an intermediate transfer member forms a ceramic film on each of plural substrates simultaneously, and mainly includes plural film-forming devices 2b1 and 2b2 each of which forms a ceramic film on each of the substrate surfaces.

Second manufacturing apparatus 2b (modification of a direct type, that performs electric discharge between facing roll electrodes to deposit a thin film) includes: first film-forming device 2b1; second film-forming device 2b2 being disposed in a substantial mirror image relationship at a predetermined distance from first film-forming device 2b1; and mixed gas supply device 24b that produces mixed gas G of at least a raw material gas and a discharge gas to supply mixed gas G to electric discharge space 23b, mixed gas supply device 24b being disposed between first film-forming device 2b1 and second film-forming device 2b2.

First film-forming device 2b1 includes: roll electrode 20a and driven roller 201 that rotatably support a substrate 175 of an endless belt shaped intermediate transfer member and rotate it in the arrow direction; tension-providing unit 202 that pulls the driven roller 201 in the arrow direction; and first power supply 25 connected to roll electrode 20a. Second film-forming device 2b2 includes: roll electrode 20b and driven roller 201 that rotatably support substrate 175 of an intermediate transfer member in an endless form and rotate it in the arrow direction; tension-providing unit 202 that pulls driven roller 201 in the arrow direction; and second power supply 26 connected to roll electrode 20b.

Further, second manufacturing apparatus 2b includes electric discharge space 23b where electric discharge is performed in a facing region between roll electrode 20a and roll electrode 20b.

Mixed gas supply device 24b supplies a mixed gas of a raw material gas, and nitrogen gas or a rare gas such as argon gas, into discharge space 23b, in order to form a film possessing at least one layer selected from an inorganic oxide layer, an inorganic nitride layer, and an inorganic carbide film. In addition, oxygen gas or hydrogen gas is more preferably mixed in order to accelerate reaction via oxidation-reduction reaction.

First power supply 25 provides a voltage of frequency $\omega 1$, second power supply 26 provides a voltage of frequency of m2, and these voltages generate electric field V where frequencies $\omega 1$ and $\omega 2$ are superposed in discharge space 23b-Electric field V plasmatizes (excites) mixed gas G. Surfaces of substrates 175 of first film-forming device 2b1 and second film-forming device 2b2 are exposed to plasmatized (excited) mixed gas, so as to deposit and form respective films (ceramic films) on the surfaces of substrate 175 of first film-forming device 2b1 and substrate 175 of second film-forming device 2b2 simultaneously, corresponding to the raw material gas contained in the plasmatized (excited) mixed gas.

Herein, facing roll electrode 20a and roll electrode 20b are disposed at a predetermined distance therebetween.

Embodiments of the atmospheric pressure plasma CVD apparatus by which ceramic film 176 is formed on substrate 175 will be described below in detail.

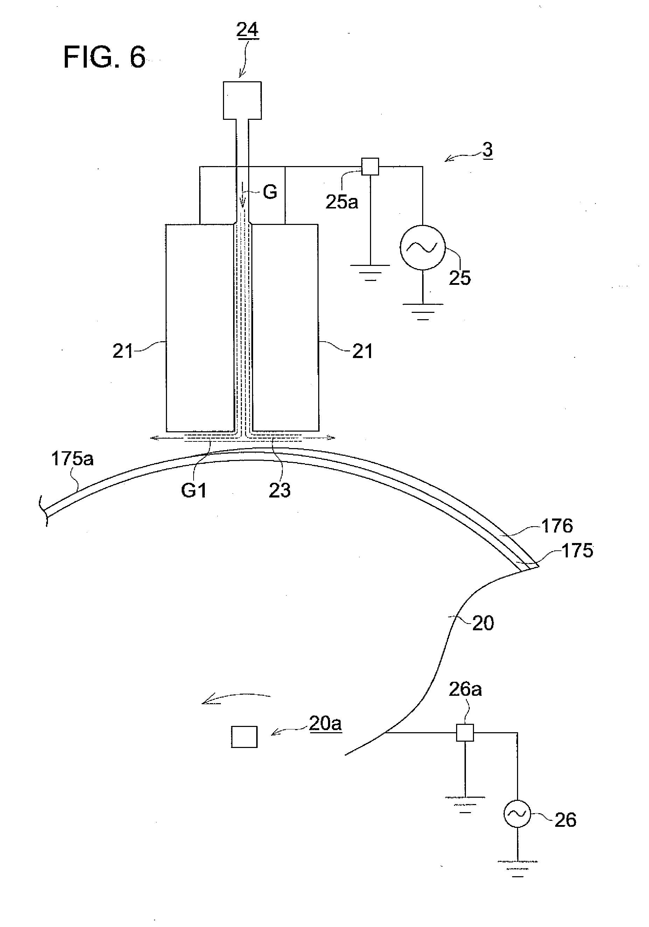

In addition, Fig. 6 is a section in which the dashed area in Fig. 4 is mainly extracted.

Fig. 6 is a schematic diagram of the first plasma film-forming apparatus to produce an intermediate transfer member employing plasma.

An example of an atmospheric pressure plasma CVD apparatus which is preferably used to form ceramic film 176 will be described, referring to Fig. 6.

Atmospheric pressure plasma CVD apparatus 3 includes at least one pair of rollers for rotatably supporting a substrate removably and rotationally drive the substrate, and includes at least one pair of electrodes for performing plasma discharge, wherein one electrode of the pair of electrodes is one roller of the pair of rollers, and the other electrode is a fixed electrode facing the one roller through the substrate. Atmospheric pressure plasma CVD apparatus 3 is an apparatus of manufacturing an intermediate transfer member and exposes the substrate to plasma generated in the facing area between the one roller and the fixed electrode so as to deposit and form the foregoing ceramic film.

Atmospheric pressure plasma CVD apparatus 3 includes, as described above, mixed gas supply device 24, fixed electrode 21, first power supply 25, first filter 25a, roll electrode 20, drive unit 20a for rotationally driving the roll electrode in the arrow direction, second power supply 26, and second filter 26a, and performs plasma discharge in discharge space 23 to excite mixed gas G of a raw material gas with a discharge gas, and exposes substrate surface 175a to excited mixed gas G1 so as to deposit and form ceramic film 176 on the substrate surface.

A first high frequency voltage of frequency of $\omega 1$ is applied to fixed electrode 21 from first power supply 25, and a high frequency voltage of frequency of $\omega 2$ is applied to roll electrode 20 from second power supply 26. Thus, an electric field is generated between fixed electrode 21 and role electrode 20 where frequency $\omega 1$ at electric field intensity $V_1$ and frequency $\omega 2$ at electric field intensity $V_2$ are superposed. Current $I_1$ flows through fixed electrode 21, current $I_2$ flows through roll electrode 20, and plasma is generated between the electrodes.

Herein, the relationship between frequency $\omega 1$ and frequency $\omega 2$, and the relationship between electric field intensity $V_1$, electric field intensity $V_2$, and electric field intensity IV that starts discharge of discharge gas satisfy $\omega 1 < \omega 2$, and satisfy $V_1 \geq IV > V_2$ or $V_1 > IV \geq V_2$, wherein the output density of the second high frequency electric field is at least 1 W/cm$^2$.

Since electric field intensity IV to start electric discharge of nitrogen gas is 3.7 kV/mm, it is preferable that at least electric field intensity $V_1$ applied from first power supply 25 is 3.7 kV/mm or higher, and electric field intensity $V_2$ applied from second high frequency power supply 60 is 3.7 kV/mm or lower.

As first power supply 25 (high frequency power supply) applicable to first atmospheric pressure plasma CVD apparatus 3, any of the following commercially available power supplies can be used.

| Applied Power supply symbol | Manufacturer | Frequency | Product name |
| --- | --- | --- | --- |
| A1 | Shinko Electric Co., Ltd. | 3 kHz | SPG3-4500 |
| A2 | Shinko Electric Co., Ltd. | 5 kHz | SPGS-4500 |
| A3 | Kasuga Electric Works, Ltd. | 15 kHz | AGI-023 |
| A4 | Shinko Electric Co., Ltd. | 50 kHz | SPG50-4500 |

(continued)

| Applied Power supply symbol | Manufacturer | Frequency | Product name |
|---|---|---|---|
| A5 | Haiden Laboratory Inc. | 100 kHz* | PHF-6k |
| A6 | Pearl Kogyo Co., Ltd. | 200 kHz | CF-2000-200k |
| A7 | Pearl Kogyo Co., Ltd. | 400 kHz | CF-2000-400k |
| A8 | SEREN IPS | 100 - 460 kHz | L3001 |

As second power supply 26 (high frequency power supply), any of the following commercially available power supplies can be used.

| Applied Power supply symbol | Manufacturer | Frequency | Product name |
|---|---|---|---|
| B1 | Pearl Kogyo Co., Ltd. | 800 kHz | CF-2000-800k |
| B2 | Pearl Kogyo Co., Ltd. | 2 MHz | CF-2000-2M |
| B3 | Pearl Kogyo Co., Ltd. | 13.56 MHz | CF-5000-13M |
| B4 | Pearl Kogyo Co., Ltd. | 27 MHz | CF-2000-27M |
| B5 | Pearl Kogyo Co., Ltd. | 150 MHz | CF-2000-150M |
| B6 | Pearl Kogyo Co., Ltd. | 22 - 99.9 MHz | RP-2000-20/100M |

Regarding the above described power supplies, the power supply marked * is an impulse high frequency power supply of Haiden Laboratory (100 kHz in continuous mode). High frequency power supplies other than the power supply marked * are capable of applying only continuous sine waves.

In the present invention, regarding the power supplied between the facing electrodes from the first and second power supplies, a power (output density) of at least 1 W/cm$^2$ is supplied to fixed electrode 21 so as to excite discharge gas, and plasma is generated to form a thin film. The upper limit of the power to be supplied to fixed electrode 21 is preferably 50 W/cm$^2$, and more preferably 20 W/cm$^2$. The lower limit is preferably 1.2 W/cm$^2$. Herein, the discharge area (cm$^2$) means the area of the range where discharge is generated at the electrode.

Further, by also supplying roll electrode 20 with a power (output density) of at least 1 W/cm$^2$, the output density can be improved while maintaining uniformity of the high frequency electric field. Thus, plasma with highly even density can be generated, which improves both a film-forming rate and film quality. The power is preferably at least 5 W/cm$^2$. The upper limit of the power to be supplied to roll electrode 20 is preferably 50 W/cm$^2$.

Herein, waveforms of high frequency electric fields are not specifically limited, and can be in continuous oscillation mode of a continuous sine wave form called a continuous mode, and also in intermittent oscillation mode called a pulse mode performing ON/OFF intermittently, either of which may be employed. However, at least, the high frequency to be supplied to roll electrode 20 preferably has a continuous sine wave to obtain a dense film exhibiting good quality.

Further, first filter 25a is provided between fixed electrode 21 and first power supply 25 to allow a current to flow easily from first power supply 25 to fixed electrode 21, and the current from second power supply 26 is grounded to inhibit a current running from second power supply 26 to first power supply 25. Second filter 26a is provided between roll electrode 20 and second power supply 26 to allow a current to flow easily from second power supply 26 to roll electrode 20, and the current from first power supply 21 is grounded to inhibit a current running from first power supply 25 to second power supply 26.

Regarding electrodes, it is preferable to employ electrodes capable of applying a high electric field, as described above, and maintaining a uniform and stable discharge state. For durability against discharge by a high electric field, the dielectric material described below is coated on at least one surface of each of fixed electrode 21 and roll electrode 20.

In the above description, regarding the relationship between the electrode and the power supply, second power supply 26 may be connected to fixed electrode 21, and first power supply 25 may be connected to roll electrode 20.

The structure of roll electrode 20 will be described below. Roll electrode 20 is constructed with a conductive base material (hereinafter, referred to also as "electrode base material") made of metal or the like, onto which a ceramic-coated dielectric material (hereinafter, also referred to simply as "dielectric material") which has been subjected to a sealing treatment with an inorganic material after thermally spraying is coated. As the ceramic material to be used for spraying, alumina, silicon nitride or the like is preferably used, but alumina is specifically preferable in view of easy workability.

Further, a roll electrode may be constructed with a conductive base material made of metal or the like onto which a lining-treated dielectric material fitted with an inorganic material by lining is coated. As the lining material, silicate glass, borate glass, phosphate glass, germinate glass, tellurite glass, aluminate glass, vanadate glass or the like is preferably used, but borate glass is specifically preferable in view of easy workability.

Examples of conductive base materials made of metal or the like include silver, platinum, stainless steel, aluminum, titanium, iron and so forth, but stainless steel is preferable in view of easy workability and cost reduction.

In the present embodiment, a stainless-steel jacket-roll base material (not shown) fitted with a cooling device by using cooling water is employed for base materials of the roll electrodes.

Fixed electrodes 21, 21a and 21b are constructed, similarly to the above-described roll electrode 20, with a conductive base material made of metal or the like, onto which a ceramic-coated dielectric material which has been subjected to a sealing treatment with an inorganic material after thermally spraying is coated. Further, fixed electrode 21' may be constructed with a conductive base material made of metal or the like, onto which a lining-processed dielectric material fitted with an inorganic material by lining is coated.

An example of a film-forming process in which ceramic film 176 is formed and deposited on substrate 175 among processes in a method of manufacturing an intermediate transfer member will be described below, referring to Figs. 4 and 6.

In Figs. 4 and 6, substrate 175 is tension-supported around roll electrode 20 and driven roller 201, then a predetermined tension is applied to substrate 175 via operation of tension-providing unit 202, and thereafter, roll electrode 20 is rotationally driven at a predetermined rotation speed.

Mixed gas supply device 24 produces mixed gas G and flows mixed gas G into electric discharge space 23.

A voltage of frequency $\omega 1$ is output from first power supply 25 to be applied to fixed electrode 21, and a voltage of frequency $\omega 2$ is output from second power supply 26 to be applied to roll electrode 20. These voltages generate electric field V in discharge space 23 with frequency $\omega 1$ and frequency $\omega 2$ superposed with each other.

Mixed gas G introduced into discharge space 23 is excited by electric field V to make a plasma state. Then, the surface of the substrate is exposed to mixed gas G in the plasma state, and ceramic film 176 possessing at least one layer selected from an inorganic oxide film, an inorganic nitride film and an inorganic carbide film is formed on substrate 175 employing a raw material gas in mixed gas G.

In such a manner, the resulting ceramic film may be a ceramic film composed of plural layers, but at least one layer among the plural layers preferably contains carbon atoms in an amount of 0.1 - 20% by weight determined via XPS measurement of the carbon atom content.

For example, in the above-described atmospheric pressure plasma CVD apparatus 3, the mixed gas (discharge gas) is plasma-excited between a pair of electrodes (roll electrode 20 and fixed electrode 21), and a raw material gas containing carbon atoms existing in this plasma is radicalized to expose the surface of substrate 175 thereto. Upon the surface of substrate 175 exposed to carbon-containing molecules and carbon-containing radicals, they are contained in the ceramic film.

A discharge gas refers to a gas being plasma-excited in the above described conditions, and can be nitrogen, argon, helium, neon, krypton, xenon or a mixture thereof. Of these, nitrogen, helium and argon are preferably employed, but nitrogen is more preferably employed in view of cost efficiency.

As a raw material gas to form a ceramic film, an organometallic gas being in a gas or liquid state at room temperature is used, and an alkyl metal compound, a metal alkoxide compound and an organometallic complex compound are specifically used. The phase state of these raw materials is not necessarily a gas phase at normal temperature and pressure. A raw material capable of being vaporized through melting, evaporating, sublimation or the like via heating or reduced pressure with mixed gas supply device 24 can be used either in a liquid phase or solid phase.

The raw material gas is one being in a plasma state in discharge space and containing a component to form a thin film, and is an organometallic compound, an organic compound, an inorganic compound or the like.

Examples of silicon compounds include silane, tetramethoxysilane, tetraethoxysilane (TEOS), tetra-n-propoxysilane, tetra-iso-propoxsilane, tetra-n-butoxysilane, tetra-t-butoxysilane, dimethyldimethoxysilane, dimethyldiethoxysilane, diethyldimethoxysilane, diphenylsimethoxysilane, methyltriethoxysilane, ethyltrimethoxysilane, phenyltriethoxysilane, (3,3,3-trifluoropropyl)trimethoxysilane, hexamethyldisyloxane, bis(dimethylamino)dimethylsilane, bis(dimethylamino)methylvinylsilane, bis(ethylamino)dimethylsilane, N,O-bis(trimethylsilyl)acetoamide, bis(trimethylsilyl)carbodiimide, diethylaminotrimethylsilane, dimethylaminodimethylsilane, hexamethyldisilazane, heaxamethylcyclotrisilazane, heptamethylsilazane, nonamethyltrisilazane, octamethylcyclotetrasilazane, tetrakisdimethyaminosilazane, tetraisocyanatesilane, tetramethyldisilazane, tris (dimethylamino)silane., triethoxyfluorosilane, allyldimethylsilane, allyltrimethylsilane, benzyltrimethylsilane, bis(trimethylsilyl)acetylene, 1,4-bistrimethylsilyl-1,3-butadiine,di-t-butylsilane, 1,3-disilabutane, bis(trimethylsilyl)methane, cyclopentanedienyltrimethylsilane, phenyldimethylsilane, phenyltrimethylsilane, propagyltrimethylsilane, tetramethylsilane, trimethylsilylacetylene, 1-(trimethylsilyl)-1-propine, tris(trimehtylsilyl)methane, tris(trimethylsilyl)silane, vinyltrimethylsilane, hexamethyldisilane, octamethylcyclotetrasiloxane, tetramethylcyclotetrasiloxane, heaxmethylcycrotetrasiloxane and M-silicate 51, but the present invention is not limited thereto.

Examples of titanium compounds include organometallic compounds such as tetradimethylamino titanium and so forth; metal hydrogen compounds such as monotitanium, dititanium and so forth; metal halogenated compounds such as titanium dichloride, titanium trichloride, titanium tetrachloride and so forth; and metal alkoxides such as tetraethoxy titanium, tetraisopropoxy titanium, tetrabutoxy titanium and so forth, but the present invention is not limited thereto.

Examples of aluminum compounds include aluminum n-butoxide, aluminum s-butoxide, aluminum t-butoxide, aluminum diisopropoxideethyl acetoacetate, aluminum ethoxide, aluminum hexafluoropentanedionato, aluminum isopropoxide, aluminum III 2, 4-pentanedionato, dimethyl aluminum chloride and so forth, but the present invention is not limited thereto.

Further, the above-described raw material may be used singly, or by mixing components of at least two kinds.

In addition, as described before, hardness of the ceramic film can be adjusted by a film-forming rate, an addition gas amount ratio, and so forth.

Ceramic film 176 is formed on the surface of support 175 to provide an intermediate transfer member exhibiting high transferability together with high cleaning ability and durability.

**EXAMPLE**

Next, the present invention will now be specifically described referring to examples, but embodiments of the present invention are not limited thereto.

1. Preparation of sample

Substrates were prepared as described below. Polyphenylenesulfide resin "E2180" (produced by Toray Co., Ltd.) 100 parts by weight Conductive filler "Furnace #3030B" (produced by Mitsubishi Chemical Corp.) 16 parts by weight Graft copolymer "MODIPER A4400" (produced by Nihon Yushi Co., Ltd.) 1 part by weight Lubricant (calcium montanate) 0.2 parts by weight

The above-described composition was put into a single-axis extruder, and molten and kneaded to prepare a resin mixture. The resin mixture was extruded into a seamless belt shape through a ring shaped die having a seamless belt-shaped discharge opening attached at the end of the extruder. The extruded seamless belt-shaped resin mixture was introduced into a cooling cylinder provided at a discharging opening, and cooled and solidified to prepare a seamless cylindrical intermediate transfer belt. The resulting substrate had a thickness of 120 $\mu$m.

Next, one inorganic compound layer of 350 nm thick as a ceramic film was formed on this substrate employing a plasma discharge treatment apparatus shown in Fig. 4. Examples of the material used for the ceramic film include titanium oxide, silicon oxide and aluminum oxide. As a usable dielectric covering each electrode fitted into the plasma discharge treatment apparatus in this case, alumina of a thickness of 1 mm was coated on each of both facing electrodes via thermally sprayed ceramic treatment. The spacing between the electrodes was set to 0.5 mm. A metal base material on which a dielectric was coated was prepared in accordance to the stainless jacket specification having a cooling function with cooling water, and the plasma discharge treatment was conducted while controlling electrode temperature with cooling water during discharging.

Examples and Comparative examples shown in Table 1 were prepared by varying film-forming conditions of the ceramic film as described below. After vapor is produced by heating each raw material, and is mixed and diluted with a discharge gas and a reactive gas which have been preheated in advance so as not to coagulate the raw material, the resulting has been supplied into the discharge space.

(Silicon oxide layer)

Discharge gas: $N_2$ gas
Reactive gas: 21% by volume of $O_2$ gas, based on the total gas
Raw material gas: 0.1% by volume of tetraethoxy silane (TEOS), based on the total gas
Power supply electric power on the low frequency side {high frequency power supply (50 kHz) manufactured by Shinko Electric Co., Ltd.}: 10 W/cm$^2$
Power supply electric power on the high frequency side {high frequency power supply (13.56 MHz) manufactured by Pearl Kogyo Co., Ltd.}: 1 - 10 W/cm$^2$

(Titanium oxide layer)

Discharge gas: $N_2$ gas
Reactive gas: 21% by volume of $O_2$ gas, based on the total gas
Raw material gas: 0.1% by volume of tetraisopropoxy titanium (TTIP), based on the total gas
Power supply electric power on the low frequency side {high frequency power supply (110 kHz) manufactured by SEREN IPS}: 10 W/cm$^2$
Power supply electric power on the high frequency side {high frequency power supply (13.56 MHz) manufactured by Pearl Kogyo Co., Ltd.}: 1 - 10 W/cm$^2$

(Aluminum oxide layer)

Discharge gas: $N_2$ gas
Reactive gas: 4.0% by volume of $H_2$ gas, based on the total gas
Raw material gas: 0.05% by volume of aluminum tri s-butoxide, based on the total gas
Power supply electric power on the low frequency side {impulse high frequency power supply (100 kHz) manufactured by Haiden Laboratory}: 10 W/cm$^2$
Power supply electric power on the high frequency side {wide band high frequency power supply (40.0 MHz) manufactured by Pearl Kogyo Co., Ltd.}: 1 - 10 W/cm$^2$

(Comparative example 1)

Similarly to Examples, film formation was conducted on a substrate, and evaluations were made.

(Silicon oxide layer)

Discharge gas: $N_2$ gas .
Reactive gas: 21% by volume of $O_2$ gas, based on the total gas
Raw material gas: 0.1% by volume of tetraethoxy silane (TEOS), based on the total gas
Power supply electric power on the low frequency side {high frequency power supply (50 kHz) manufactured by Shinko Electric Co., Ltd.}: 3 W/cm$^2$
Power supply electric power on the high frequency side {high frequency power supply (13.56 MHz) manufactured by Pearl Kogyo Co., Ltd.}: 0.5 W/cm$^2$
Maintained substrate temperature: 20 °C

(Comparative example 2)

Similarly to Examples, film formation was conducted on a substrate employing a plasma CVD apparatus Model PD-270STP manufactured by SAMCO, Inc., and evaluations were made. Film formation was conducted only on a part of a belt for film forming apparatus reasons, and only the film-formed part was evaluated.

(Silicon oxide layer)

Discharge gas: $O_2$ gas at 0.08 torr
Reactive gas: Tetraethoxy silane (TEOS) 5 sccm

(standard cubic centimeter per minite)

Electric power: 13.56 MHz at 100 W
Maintained substrate temperature: 60 °C

2. Evaluation method

(1) Evaluation method of secondary transfer ratio of toner

The secondary transfer ratio is a ratio of "toner weight of a toner image transferred onto a recording paper sheet" to "toner weight of a toner image formed on an intermediate transfer member", and the evaluation was conducted as described below.
Test printing is conducted on a Konica Minolta CF paper sheet in the maximum toner density for yellow, magenta, cyan and black with a polymerization toner having an average particle diameter of 6.5 µm employing Magicolor 5440DL (produced by Konica Minolta Holdings, Inc.) fitted into a printer. A toner adhering amount on a test print paper sheet and a residual toner amount on a belt were converted into the toner adhering amount from the measured result of optical (reflection) density to obtain a toner transfer ratio.

$$\text{Transfer ratio (\%)} = \{\text{Toner adhering amount on test print paper sheet / (Toner adhering amount on test print paper sheet + Residual toner amount on belt)}\}$$

A: A transfer ratio of not less than 95%
B: A transfer ratio of not less than 90% and less than 95%
C: A transfer ratio of less than 90%

(2) Cleaning ability

After cleaning the surface of an intermediate transfer member with a cleaning blade, employing the above-described printer, the surface condition of the intermediate transfer member was visually observed to confirm the adhering condition to toner. The evaluation was ranked as follows.

A: No residual toner is observed.
B: Slight residual toner is observed, but practically with no problem.
C: Residual toner is observed, and practically with a problem.

(3) Durability test

Printing of 160,000 paper sheets was made with a test pattern having an image ratio of 5% for each color, and Konica Minolta CF paper (A4 in size), employing the above-described printer.
Subsequently, the secondary transfer ratio of toner was evaluated, and the print quality was visually observed in comparison to those at the initial stage of printing. The evaluation was ranked as follows.

A: No change is observed even after printing 200,000th print (OK),
B: Slight change is observed, but practically with no problem.
C: Change is observed, and practically with a problem (NG).

As to the above-described items, measured results and evaluation results of Examples 1 - 3 and Comparative examples 1 - 2 are shown in Table 1.

Table 1

| *1 | Inorganic compound layer | | | | *3 | *4 | Durability | |
|---|---|---|---|---|---|---|---|---|
| | *2 | Density ratio | Interal stress (MPa) | Thickness (nm) | | | | |
| 1 | $SiO_2$ | 0.75 | 10 | 350 | B | B | C | Comp.1 |
| 2 | $SiO_2$ | 0.81 | 20 | 350 | A | A | A | Ex.1 |
| 3 | $SiO_2$ | 0.9 | 30 | 350 | A | A | A | Ex. 2 |
| 4 | $SiO_2$ | 0.98 | 50 | 350 | A | A | A | Ex.3 |
| 5 | $SiO_2$ | 0.99 | 95 | 350 | A | A | A | Ex. 4 |
| 6 | $SiO_2$ | 0.98 | 200 | 350 | A | A | C | Comp. 2 |
| 7 | $SiO_2$ | 0.98 | 70 | 500 | A | A | A | Ex. 5 |
| 8 | $SiO_2$ | 0.98 | 90 | 800 | A | A | A | Ex.6 |
| 9 | $TiO_2$ | 0.95 | 40 | 250 | A | A | A | Ex.7 |

(continued)

| *1 | Inorganic compound layer | | | | *3 | *4 | Durability | |
|---|---|---|---|---|---|---|---|---|
| | *2 | Density ratio | Interal stress (MPa) | Thickness (nm) | | | | |
| 10 | $Al_2O_3$ | 0.85 | 40 | 250 | A | A | A | Ex. 8 |
| *1: Sample No.<br>*2: Material<br>*3: Transfer efficiency<br>*4: Cleaning ability<br>Comp.: Comparative example<br>Ex.: Example | | | | | | | | |

As is clear from results in Table 1, it is to be understood that by employing an intermediate transfer member comprising one ceramic film or more on a substrate, wherein the ceramic film has a density $\rho f$, and another ceramic film having the same composition ratio as that of the ceramic film, that is formed via thermal oxidation or thermal nitridation of a base material, has a density of $\rho b$, which has a feature satisfying that density Y (= $\rho f/\rho b$) is $1 \geq Y > 0.8$, provided can be an intermediate transfer member exhibiting excellent transfer efficiency, together with excellent cleaning ability and durability, a method of manufacturing the intermediate transfer member, and an image forming apparatus fitted with the intermediate transfer member.

**Claims**

1. An intermediate transfer member comprising a ceramic film provided on a substrate,
   wherein the ceramic film has a density of $\rho f$, satisfying the following formula:

$$0.8 < \rho f/\rho b \leq 1$$

   provided that another ceramic film having the same composition ratio as that of the ceramic film has a density of $\rho b$, when the another ceramic film is formed via thermal oxidation or thermal nitridation of a base material.

2. The intermediate transfer member of Claim 1,
   wherein the ceramic film having the density of $\rho f$ has a residual stress as a compression stress of 0.01 - 100 MPa.

3. The intermediate transfer member of Claim 1 or 2,
   wherein a material constituting the ceramic film having the density of $\rho f$ is silicon oxide, silicon oxide-nitride, silicon nitride, titanium oxide, titanium oxide-nitride, titanium nitride, aluminum oxide, or a mixture thereof.

4. The intermediate transfer member of any one of Claims 1 - 3,
   wherein the ceramic film having the density of $\rho f$ is silicon oxide has a thickness of 200 - 1000 nm.

5. A method of manufacturing the intermediate transfer member of any one of Claims 1 - 4, comprising the steps of:

   supplying a gas comprising a thin film forming gas into a discharge space at atmospheric pressure or approximately atmospheric pressure;
   applying a high frequency electric field to the discharge space to excite the gas; and
   exposing a substrate to the excited gas to form the ceramic film on a surface of the substrate.

6. An image forming apparatus comprising:

   a device of developing a surface of an image carrier to form a toner image;
   a device of transferring the toner image into an intermediate transfer member; and
   a device of further transferring the toner image onto a transfer paper sheet,

   wherein the intermediate transfer member is the intermediate transfer member of any one of Claims 1 - 4.

# FIG. 1

# FIG. 2

# FIG. 3

# FIG. 4

## FIG. 5

FIG. 6

## INTERNATIONAL SEARCH REPORT

International application No.

PCT/JP2006/322141

| A. CLASSIFICATION OF SUBJECT MATTER |
|---|
| *G03G15/16(2006.01)i, C23C16/30(2006.01)i* |

According to International Patent Classification (IPC) or to both national classification and IPC

| B. FIELDS SEARCHED |
|---|

Minimum documentation searched (classification system followed by classification symbols)
G03G15/16, C23C16/30

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

| C. DOCUMENTS CONSIDERED TO BE RELEVANT |

| Category* | Citation of document, with indication, where appropriate, of the relevant passages | Relevant to claim No. |
|---|---|---|
| Y | JP 2003-302774 A  (Konica Minolta Holdings Kabushiki Kaisha), 24 October, 2003 (24.10.03), Claims 1, 4; Par. Nos. [0062] to [0063], [0128], [0136] to [0137], [0161] (Family: none) | 1-6 |
| Y | JP 11-125980 A  (Ricoh Co., Ltd.), 11 May, 1999 (11.05.99), Claim 1; Par. No. [0055] (Family: none) | 1-6 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 25 December, 2006 (25.12.06) | 09 January, 2007 (09.01.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9212004 A
- JP 2001347593 A